# EUROPEAN PATENT SPECIFICATION

(11) **EP 1 436 237 B1**
(45) Date of publication and mention of the grant of the patent: **07.03.2007**
(21) Application number: 02747799.1
(22) Date of filing: 09.07.2002
(51) Int. Cl.: C03C 27/00, H05K 3/00, H01L 21/473

(54) **BONDING METHOD AND PRODUCT**
VERBINDUNGSVERFAHREN UND PRODUKT
PROCEDE ET PRODUIT DE LIAISON

(30) Priority: 09.07.2001 SE 0102476
(43) Date of publication of application: 14.07.2004
(73) Proprietor: IMEGO AB, 411 33 Göteborg (SE)
(72) Inventor: BERGSTEDT, Leif, S-518 40 Sjömarken (SE); PERSSON, Katrin, S-421 63 Västra Frölunda (SE)
(74) Representative: Egeröd, Lisbeth
(86) International application number: PCT/SE2002/001371
(87) International publication number: WO 2003/006396

(56) References cited:
- US-A- 5 801 068
- US-A- 5 938 911
- PATENT ABSTRACTS OF JAPAN vol. 16, no. 15 (P-1298) 14 January 1992 & JP 03 233 429 A (MITSUBISHI ELECTRIC CORP) 17 January 1991

## Description

### TECHNICAL FIELD OF THE INVENTION

The present invention relates to a method of anodic bonding a first structure to a glass structure.

### BACKGROUND

It is known to bond glass to a substrate such a Low Temperature Co-fired Ceramic (LTCC) using high electrical voltage.

EP 742 581, for example, relates to a method for making sealed cavities on silicon wafer surfaces by anodic bonding and with electrically insulated conductors through the sealing areas to connect functional devices inside the cavities to electrical terminals outside said cavities. The conductors are provided by the use of doped buried crossings in a single crystal silicon substrate, thereby also allowing different kinds of integrated silicon devices, e.g. sensors to be made.

The technique is that Borosilicate glass plates are bonded onto a silicon (Si) wafer using so-called anodized bonding. A plate of glass is arranged on a Si wafer under an amount of pressure. The Si wafer and the glass are then heated up to some hundred degrees and a voltage is applied across the plates (glass and wafer) whereby the glass, which contains sodium (Na) ions migrate into the Si wafer, and a hermetic junction is obtained.

When two Si wafers are to be connected, a similar method as mentioned above is carried out, however, one of the wafers is coated with sputtered borosilicate glass and an anodized bonding is performed.

Generally, to be able to achieve an anodized bonding the object intended to be bonded to Si must contain Na-ions, usually through doping a glass with Soda lime glass. The reason for using borosilicate glass is that it matches the Si wafer characteristics, especially with respect to coefficient of expansion.

US 5,455,385 discloses a packaging assembly for a semiconductor circuit chip is formed of a hermetically sealable, 'tub'-like structure. The tub-like structure is comprised a laminated stack of thin layers of LTCC material. The laminated stack of LTCC layers contains an internally distributed network of interconnect links through which a semiconductor die, that has been mounted at a floor portion of the tub, may be electrically connected to a plurality of conductive recesses or pockets located at top and bottom sidewall edge portions of the tub, thereby allowing multiple tubs to be joined together as a hermetically sealed assembly and electrically interconnected at the conductive pockets of adjacent tubs.

In US 5,600,541, a 3-D integrated circuit (IC) chip stack employs a plurality of discrete chip carriers that are formed from dielectric tape layers such as fused LTCC tape. The chips are lodged in cavities within the tape layers, and are either flip-chip or wire bond connected to electrical routings that extend along one or more tape layers toward the periphery of the carrier. Intercarrier interconnects are provided between the routings for adjacent carriers, either through the carrier sidewalls or externally. The carriers are mechanically secured to each other within the stack either by connectors that also provide an I/O signal capability, or by an adhesive if external electrical connectors are used. The structure is strong, compact, inexpensive, compatible with conventional IC chips and capable of disassembly and reassembly to replace a bad chip.

According to US 5,176,771, a plurality of sheets of LTCC tape or other fusible ceramic tape are laminated together. A pattern is printed on an external surface of the laminated structure of a material having a thermal shrinkage rate, which is different from that of the tape. The pattern may be printed before or after lamination. The structure is then baked to burn organic materials out of the tape. During this step, the pattern and underlying portions of the upper tape sheet shrink to a different extent than the bulk of the structure, and delaminate therefrom to form cavities having the same shape as the pattern. The structure is then fired to sinter the tape and form a fused multilayer substrate. The cavities may be filled with an electrically conductive or resistive material. Conductor traces, which are considerably thicker, than can be fabricated using conventional thick film technology may be formed by filling cavities with conductive material, and printing material that is more conductive over the material in the cavities. Alternatively, cavities may be filled with an adhesive for bonding a component such as a coverlid to a multilayer substrate.

An electrical circuit pattern is formed on a glass-ceramic, thermally fusible tape, according to US 5,028,473. The tape is heated to a temperature at which it becomes temporarily plastic, and is then bent into a desired non-planar shape. Further application of heat causes the tape to be sintered in the non-planar shape. A multi-layer structure can be provided by laminating plural layers of Low-Temperature-Cofired-Ceramic (LTCC) tape with respective circuit patterns formed thereon together, and plastically bending the laminated structure into the non-planar shape during the heating step. A circuit structure including an edge connector can be formed by laminating a layer of glass-ceramic transfer tape having an electrical circuit pattern, which includes conductor strips formed on an edge connector portion thereof onto a relatively rigid substrate, such that the edge connector portion is bent around an edge of the substrate to form a rigid edge connector. The edge connector portion of the transfer tape, which is formed into a non-planar shape during the lamination step, is fused together with the remaining portion of the transfer tape onto the substrate during the heating step.

None of the prior art teaches or gives a hint to carry out the technique according to the present invention.

US 5,801,068 relates to a microelectronic device hermetically sealed at the wafer level. A substrate is provided having associated electronics and at least one metal bonding pad. A dielectric layer, such as Pyrex glass film, is sputter deposited atop the substrate to form a glass/metal seal. A glass film is thereafter planarized, preferably by chemical-mechanical polishing, to remove surface variations. A cover wafer is thereafter anodically bonded to the dielectric layer/glass film to define a sealed cavity for housing and protecting the substrate electronics. The resultant microelectronic device is packaged in its own hermetically sealed container at the wafer level. However, this invention dose not employ the dipole principle of the present invention by applying a low voltage between the dipoles. The anodic bonding is achieved through conventional methods.

### SUMMARY

The object of the invention is to provide a method for applying anodic bonding using low voltage.

Therefore the initially mentioned method comprises the steps of: arranging a conductive pattern on a substrate; providing the glass layer on said conductive pattern; providing said first structure on said glass layer; providing an electrode on one side of said first structure, and applying a voltage to said conductive pattern and said electrode to obtain an electrical field across said first structure and said glass layer, between said conductive pattern (11) and said electrode produce an anodic bonding between said first structure and said glass layer.

Preferably, said first structure is made of silicon, LTCC (Low Temperature Co-fired Ceramic) or HTCC (High Temperature Co-fired Ceramic). The glass layer may contain sodium (Na) ions. For providing a shorter distance between the electrodes, said conductive pattern is arranged on one side of a substrate and connected to another side of said substrate through a via. The glass layer can be applied through screen-printing or lithography and covers said conductive pattern at least partly.

### BRIEF DESCRIPTION OF THE DRAWINGS

In the following, the invention will be further described in a non-limiting way under reference to the accompanying drawings in which:
- Fig. 1: schematically illustrates a cross-sectional view of a bonding object,
- Fig. 2: illustrates a top view of the object according to Fig.1, and
- Fig. 3: illustrates in a schematic way one stage of the bonding process, according to the invention.

### DETAILED DESCRIPTION OF THE EMBODIMENT

The objects of the invention are achieved by applying an electrically conductive pattern on a first side of a substrate preferably LTCC, HTCC (High Temperature Co-fired Ceramic) or the like and under a glass pattern, intended to be bonded. The conductive pattern is then connected through the substrate to the second (opposite) side of the substrate, which is the connection face. Thus, for bonding there is needed a bonding voltage for bonding through the glass pattern and not through the entire substrate, resulting in a much lower anodic bonding voltage.

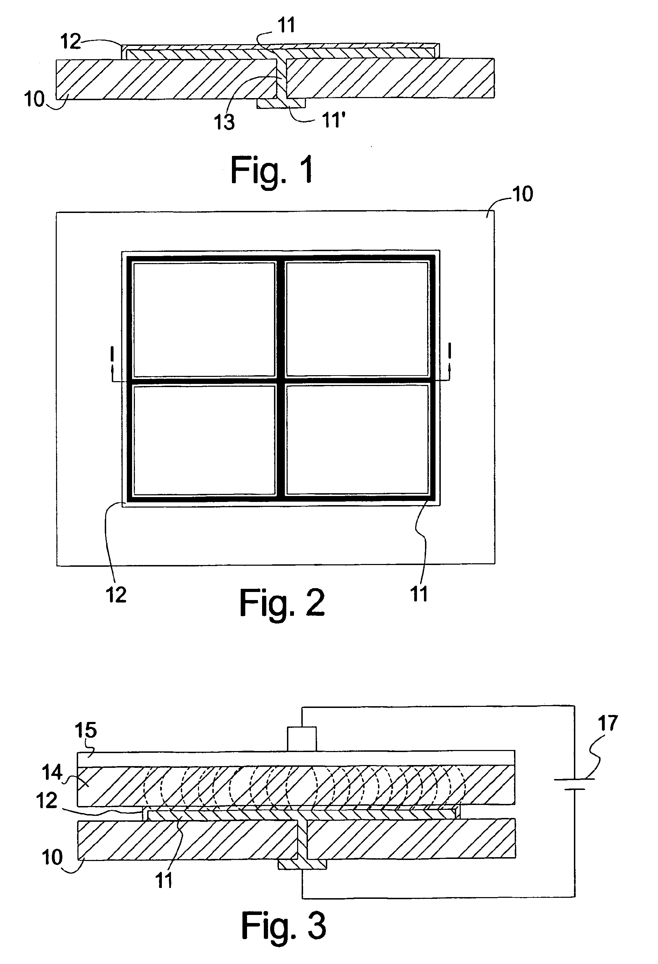

Figs. 1 and 2 illustrate an arrangement according to the invention. Fig. 1 is a cross-section through a substrate 10 and Fig. 2 is a lateral view of the substrate. The substrate 10, such as LTCC, HTCC or the like provided with a conductive pattern 11 and a coating of glass 12, covering the entire or parts of the conductive pattern 11. The glass coating can be applied through screen-printing, lithography, etc. The conductive pattern 11 and 11' at opposite sides of the substrate are connected through a via 13.

The bonding process is illustrated in Fig. 3.

The technique comprises bonding borosilicate glass plates 12 onto a silicon (Si) wafer 14 using anodized bonding. The Si wafer and the glass after application of the glass are heated up to some hundred degrees. A voltage is connected to the conductive pattern under the glass through the via connection at one side and an electrode15 at the other side of the wafer 14. A low voltage is then applied across the plates (glass and wafer) whereby the glass, which at least partly contains sodium (Na) ions migrate into the Si wafer, and a hermetic junction is obtained. The electrical field between the electrodes is illustrated with hatched lines. Due to the distance between the electrode and the conductive pattern under the glass, much less voltage is needed for achieving the bonding. Experiments have shown that the relation between voltage and the thickness between the electrodes can be 1V/1 µm.

Generally, to be able to achieve an anodized bonding, the object intended to be bonded to Si must contain Na-ions, usually through doping a glass with Soda lime glass. The reason for using borosilicate glass is that it matches the Si wafer characteristics, especially with respect to coefficient of expansion.

Fig. 3 illustrates one stage of the bonding process. A silicon wafer, plate LTCC, or HTCC structor14 to be bonded is placed on top of the glass layer 12. On one side of the plate 14 is arranged an electrode plate 15. The electrode plate and the conductive pattern 11 under the glass through the via are connected to the terminals of an energy source 17 so that an electrical field is generated between the plate and the conductive pattern 11. Thus, sodium (Na) ions of the glass migrate into the Si wafer, and a hermetic junction/sealing is obtained. The amount of voltage depends on the glass thickness, as mentioned above, for example for a glass layer having a thickness of 12 µm a voltage of 12 V is needed. It is comparable to the voltage used today, which is about 500 V.

The invention is not limited the shown embodiments but can be varied in a number of ways without departing from the scope of the appended claims and the arrangement and the method can be implemented in various ways depending on application, functional units, needs and requirements etc.

## Claims

1. An anodic bonding method for attaching a first structure (14) to a glass layer (12), comprising the steps of:
- arranging a first conductive pattern (11) and a second conductive pattern (11') on opposite side of a substrate (10),
- connecting said first and second conductive patterns (11, 11') through a via (13),
- providing the glass layer (12) on said conductive pattern (11),
- positioning said first structure (14) on said glass layer (12),
- providing a first electrode (15) on one side of said first structure (14),
- applying a voltage to said via and said first electrode (15) to obtain an electrical field across said first structure (14) and said glass layer (12), and
- producing an anodic bonding between said first structure and said glass layer, which anodic bonding attaches said first structure (14) to said glass layer (12).

2. The method of claim 1, wherein said first structure is made of silicon, LTCC (Low Temperature Co-fired Ceramic) or HTCC (High Temperature Co-fired Ceramic).

3. The method of claim 1, wherein said glass layer contains sodium (Na) ions.

4. The method according to any of claims 1- 4, wherein said glass layer is applied through screen-printing or lithography.

5. The method according to any of claims 1- 5, wherein said glass layer covers said conductive pattern at least partly.

6. An anodic bonded structure obtained by the method according to any of claims 1 to 5.

## Patentansprüche

1. Verfahren zum anodischen Bonden zum Anbringen einer ersten Struktur (14) an einer Glasschicht (12), umfassend die Schritte:
- Anordnen eines ersten leitenden Musters (11) und eines zweiten leitenden Musters (11') an entgegengesetzten Seiten eines Substrats (10),
- Verbinden der ersten und zweiten leitenden Muster (11, 11') über eine Durchkontaktierung (13),
- Vorsehen der Glasschicht (12) an dem leitenden Muster (11),
- Positionieren der ersten Struktur (14) an der Glasschicht (12),
- Vorsehen einer ersten Elektrode (15) an einer Seite der ersten Struktur (14),
- Anlegen einer Spannung an die Durchkontaktierung und die erste Elektrode (15), um ein elektrisches Feld über die erste Struktur (14) und die Glasschicht (12) zu erhalten, und
- Herstellen einer anodischen Verbindung zwischen der ersten Struktur und der Glasschicht, wobei die anodische Verbindung die erste Struktur (14) an der Glasschicht (12) anbringt.

2. Verfahren nach Anspruch 1, wobei die erste Struktur hergestellt ist aus Silizium, LTCC ("Low Temperature Co-fired Ceramic", bei Niedertemperatur simultan gesinterte Keramik) oder HTCC ("High Temperature Co-fired Ceramic", bei Hochtemperatur simultan gesinterte Keramik).

3. Verfahren nach Anspruch 1, wobei die Glasschicht Natrium (Na) -Ionen enthält.

4. Verfahren nach einem der Ansprüche 1-3, wobei die Glasschicht durch einen Schablonendruck oder durch Lithographie aufgebracht wird.

5. Verfahren nach einem der Ansprüche 1-4, wobei die Glasschicht das leitende Muster wenigstens teilweise bedeckt.

6. Anodisch gebondete Struktur, welche man mit dem Verfahren nach einem der Ansprüche 1-5 erhält.

## Revendications

1. Procédé de liaison anodique pour attacher une première structure (14) à une couche de verre (12), comportant les étapes consistant à :
- agencer un premier motif conducteur (11) et un second motif conducteur (11') sur un côté opposé d'un substrat (10),
- connecter lesdits premier et second motifs conducteurs (11, 11') à travers un trou d'interconnexion (13),
- agencer la couche de verre (12) sur ledit motif conducteur (11),
- positionner ladite première structure (14) sur ladite couche de verre (12),
- agencer une première électrode (15) sur un premier côté de ladite première structure (14),
- appliquer une tension audit trou d'interconnexion et à ladite première électrode (15) pour obtenir un champ électrique à travers ladite première structure (14) et ladite couche de verre (12), et
- produire une liaison anodique entre ladite première structure et ladite couche de verre, laquelle liaison anodique attache ladite première structure (14) à ladite couche de verre (12).

2. Procédé selon la revendication 1, dans lequel ladite première structure est constituée de silicium, LTCC (céramique co-cuite à basse température) ou HTCC (céramique co-cuite à haute température)

3. Procédé selon la revendication 1, dans lequel ladite couche de verre contient des ions sodium (Na).

4. Procédé selon l'une quelconque des revendications 1 à 4, dans lequel ladite couche de verre est appliquée par l'intermédiaire d'une sérigraphie ou lithographie.

5. Procédé selon l'une quelconque des revendications 1 à 5, dans lequel ladite couche de verre recouvre ledit motif conducteur au moins partiellement.

6. Structure liée par liaison anodique obtenue par le procédé selon l'une quelconque des revendications 1 à 5.
